# EUROPÄISCHE PATENTANMELDUNG

(11) **EP 4 366 481 A1**
(43) Veröffentlichungstag der Anmeldung: **08.05.2024**
(21) Anmeldenummer: 22205665.7
(22) Anmeldetag: 04.11.2022
(51) Int. Cl.: H05K 7/20

(54) **RACK-KÜHLMODUL FÜR EIN TRÄGERRACK**

(71) Anmelder: Rohde & Schwarz GmbH & Co. KG, 81671 München (DE)
(72) Erfinder: Schwarz, Matthias, 83022 Rosenheim (DE); Gegenfurtner, Korbinian, 84036 Landshut (DE)
(74) Vertreter: Isarpatent

(57) **Zusammenfassung**

Rack-Kühlmodul für ein Trägerrack, wobei das Rack-Kühlmodul an einer Abluftseite des Trägerracks zum Kühlen einer von Komponenten des Trägerracks erwärmten Luftströmung, die quer zu einem Bedienfeld des Trägerracks horizontal verläuft, anbringbar ist.

## Beschreibung

Trägerracks werden vielseitig eingesetzt, insbesondere bei Schaltschänken, welche Geräte beinhalten. Trägerracks verfügen an ihrer Vorderseite über ein Bedienfeld zur Bedienung der in dem Trägerrack verbauten Geräte.

Die Komponenten der innerhalb des Trägerracks verbauten Geräte erzeugen während des Betriebes Wärme, die durch Kühleinrichtungen abgeführt werden kann. Herkömmliche Rack-Kühleinrichtungen kühlen die Komponenten der in dem Trägerrack verbauten Komponenten mit einem Luftstrom, welcher zwischen der Vorderseite des Trägerracks und einer Rückseite des Trägerracks entlang der zu kühlenden Komponenten entlangströmt.

Eine unzureichende Kühlung kann zu einer Raum- und Komponentenüberhitzung führen. Ein Grund hierfür ist die permanente Erhöhung der eingebrachten Wärmelasten aufgrund immer höherer Leistungsanforderungen der Komponenten.

Herkömmliche Kühlsysteme von Trägerracks, insbesondere Umluft-Kühlgeräte, führen meist zu einer starken Lärmentwicklung, da sie Ventilatoren einsetzen, die eine große Luftmenge befördern müssen und dementsprechend mit einer hohen Lüfter-Drehzahl arbeiten.

Es kommt ferner zu ungewollten Luftzugerscheinungen durch starke Luftumwälzungen innerhalb des Raumes.

Weiterhin führt die Verwendung von herkömmliche Kühlsystemen bei Trägerracks zu einer schlechten Temperaturverteilung durch unterschiedlichen Wärmelasten, die teilweise eine Überhitzung der Komponenten bewirken. Zudem bieten herkömmliche Kühlsysteme von Trägerracks keine stabile und präzise Temperaturregelung der Temperatur innerhalb der Geräte. Herkömmliche Kühlsysteme von Trägerracks haben jedoch nur eine geringe Energieeffizienz.

Es ist daher eine Aufgabe der vorliegenden Erfindung eine Kühlvorrichtung für ein Trägerrack zu schaffen, welche die genannten Nachteile eines herkömmlichen Kühlsystems vermeidet und eine präzise und stabile Temperaturregelung bietet.

Diese Aufgabe wird durch ein Rack-Kühlungsmodul mit den im Patentanspruch 1 angegebenen Merkmalen gelöst.

Die Erfindung schafft demnach ein Rack-Kühlungsmodul für ein Trägerrack, das an einer Abluftseite des Trägerracks zum Kühlen einer von Komponenten des Trägerracks erwärmten Luftströmung, welche quer zu einem Bedienfeld des Trägerracks horizontal verläuft, anbringbar ist.

Bei einer möglichen Ausführungsform weist das Rack-Kühlungsmodul mehrere übereinander angeordnete Kühlsegmente aufweist.

Bei einer möglichen Implementierung weist das Rack-Kühlungsmodul vier Kühlsegmente auf.

Bei einer möglichen Ausführungsform weist das Kühlungssegment einen steuerbaren Luftventilator auf, der zum Ansaugen der von Komponenten des Trägerracks erwärmten Luftströmung durch den zugehörigen Luftfilter hindurch in das Kühlsegment vorgesehen ist.

Bei einer möglichen Ausführungsform weist das Kühlsegment einen Wärmetauscher auf, der über ein steuerbares Regelventil mit einem Kaltwassernetz verbunden ist.

Bei einer möglichen Ausführungsform erhält das steuerbare Regelventil des Kühlsegments Steuersignale über einen Feld-Bus von einer externen Steuerung.

Bei einer möglichen Ausführungsform weist das Kühlsegment einen Wärmesensor zur Messung einer lokalen Temperatur innerhalb des Kühlsegments auf.

Bei einer möglichen Ausführungsform ist der Wärmesensor des Kühlsegments ein Kanal-Mittelwertfühler ist.

Bei einer möglichen Ausführungsform erzeugt der Wärmesensor Temperaturdaten, die über einen Feld-Bus an eine externe Steuerung übertragen werden.

Bei einer möglichen Ausführungsform weist das Kühlsegment eine Kondenswasser-Wanne zur Aufnahme von Kondenswasser auf, das sich innerhalb des Kühlsegments bildet.

Bei einer möglichen Ausführungsform läuft das in der Kondenswasser-Wanne des Kühlsegments aufgenommene Kondenswasser über einen Ablauf in einen Sammelbehälter des Rack-Kühlungsmoduls ab, der einen Leckage-Sensor zur Erfassung von in dem Sammelbehälter gesammelten Kondenswasser und eine Kondenswasser-Pumpe zum Abpumpen des in dem Sammelbehälter gesammelten Kondenswassers aufweist.

Bei einer möglichen Ausführungsform ist der Leckage-Sensor des Sammelbehälters über einen Feld-Bus mit einer externen Steuerung verbunden und meldet das Vorhandensein von Kondenswasser in dem Sammelbehälter an die externe Steuerung.

Bei einer möglichen Ausführungsform vergleicht die Steuerung die von dem Wärmesensor eines Kühlsegments gemessene Ist-Temperatur mit einer Soll-Temperatur des betreffenden Kühlsegments und steuert das Regelventil des Kühlsegments zum Erreichen der Soll-Temperatur individuell an.

Bei einer möglichen Ausführungsform ist das Rack-Kühlungsmodul als Slave über einen Feld-Bus zur Datenübertragung an eine externe Steuerung als Master angeschlossen.

Bei einer möglichen Ausführungsform weist der Feld-Bus Stromversorgungsleitungen zur Stromversorgung der Kühlsegmente des Rack-Kühlungsmoduls auf.

Bei einer möglichen Ausführungsform ist das Rack-Kühlungsmodul werkzeuglos an die Abluftseite des Trägerracks anbringbar.

Die Erfindung schafft ferner ein Kühlsystem mit den im Patenanspruch 17 angegebenen Merkmalen.

Die Erfindung schafft demnach ein Kühlsystem zum Kühlen von mehreren Trägerracks innerhalb eines Integrationsraumes, wobei an einer Abluftseite eines jeden Trägerracks ein zugehöriges Rack-Kühlungsmodul angebracht ist.

Bei einer möglichen Ausführungsform des Kühlsystems trägt das Trägerrack Messgeräte deren Komponenten während des Betriebes Wärme erzeugen, die an der Abluftseite des Trägerracks an das zugehörige Rack-Kühlungsmodul abgeführt wird.

Mögliche Ausführungsformen des erfindungsgemäßen Rack-Kühlmoduls und des Kühlsystems werden unter Bezugnahme auf die beigefügten Figuren näher beschrieben.

Es zeigen:
Fig.1 ein Ausführungsbeispiel eines erfindungsgemäßen Kühlsystems mit zwei Trägerracks und zugehörigen Rack-Kühlmodulen, die über einen Feld-Bus miteinander verbunden sind;
Fig.2 ein Ausführungsbeispiel eines erfindungsgemäßen Rack-Kühlmoduls mit mehreren Kühlsegmenten.

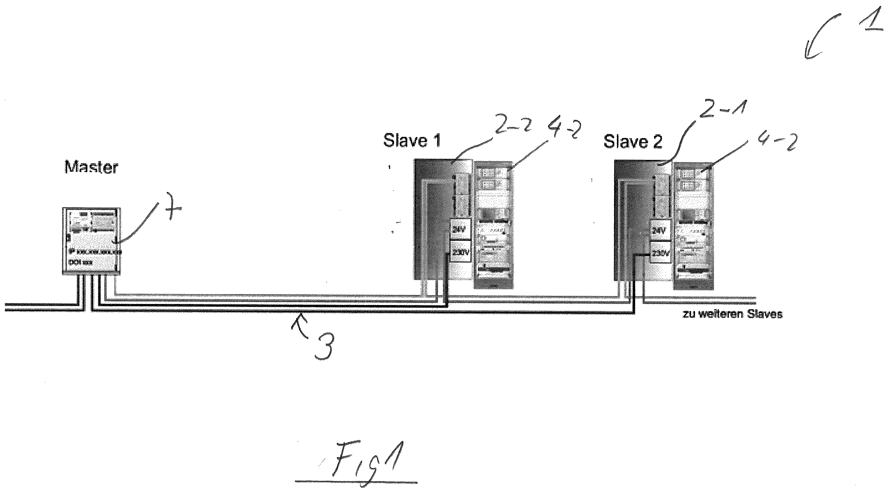

Fig.1 zeigt schematisch eine mögliche Ausführungsform eines Kühlsystems 1. Das Kühlsystem 1 umfasst mehrere Rack-Kühlmodule 2, die über einen gemeinsamen Feld-Bus 3 miteinander verbunden sind. Jedes Rack-Kühlmodul 2 des Kühlsystems 1 ist an der Abluftseite eines zugehörigen Trägerracks 4 angebracht.

Bei dem in Fig. 1 dargestellten Ausführungsbeispiel befindet sich die Abluftseite des Trägerracks 4 links, d.h. ein erwärmter Abluftstrom gelangt von den Geräten, die durch das Trägerrack 4 getragen werden, in das links an dem Trägerrack 4-i angebrachte zugehörige Rack-Kühlungsmodul 2-i. Von dort gelangt der Luftstrom in das nächste links vom Rack-Kühlungsmodul 2-i gelegene Trägerrack 4-(i+1) usw. bis der Luftstrom durch das letzte Rack-Kühlungsmodul 2-N hindurch links an die Umgebung abgegeben wird. Der kühlende Luftstrom ist im wesentliche horizontal ausgerichtet, d.h. horizontal im Aufstellungsraum der Trägerracks 4.

Bei dem in Fig. 1 dargestellten Kühlsystem 1 sind eine bestimmte Anzahl N (N=2) von Trägerracks 4 und zugehörigen Rack-Kühlungsmodulen 2 vorgesehen. Diese Anzahl N kann für unterschiedliche Anwendungsfälle variieren. Die Anzahl der Kühlsegmente 5 kann bei einer möglichen Ausführungsform der Anzahl von Messgeräten innerhalb des zugehörigen Trägerracks 4 oder der Anzahl von Zwischenräumen zwischen den Messgeräten entsprechen.

Figur 1 ist eine schematische Darstellung. Bei der tatsächlichen Anordnung besteht keine räumliche Lücke zwischen den Paaren von Trägerracks 4 und zugehörigen Kühlmodulen 2, d.h. die Slaves 1,2 stehen im Raum direkt nebeneinander und es besteht somit eine Sandwich-Anordnung in der Kühlmodule 2 und Trägerracks 4 horizontal nebeneinander gestapelt angeordnet sind. Hierdurch wird der für das Kühlsystem 1 benötigte Platz minimiert.

Jedes Rack-Kühlmodul 2 ist für ein zugehöriges Trägerrack 4 vorgesehen. Das Rack-Kühlmodul 2 ist an der Abluftseite des Trägerracks 4 zum Kühlen einer von Komponenten des Trägerracks 4 erwärmten Luftströmung, welche quer zu einem Bedienfeld des Trägerracks 4 horizontal verläuft, angebracht. Das Bedienfeld des Trägerracks 4 bzw. der darin montieren Geräte, insbesondere Messgeräte, befindet sich an dessen Vorderseite.

Bei dem in Fig.1 dargestellten Ausführungsbeispiel ist sind die Luftströmungen von rechts nach links gerichtet. Bei einer alternativen Ausführungsform kann das Rack-Kühlmodul 2 auch an der rechten Seite des zugehörigen Trägerracks 4 angebracht sein, d.h. die Luftströmung ist bei dieser Ausführungsform umgekehrt von links nach rechts gerichtet.

Die transportierte Luftströmungsmenge beträgt insgesamt bei einer möglichen Implementierung des Kühlsystems 1 etwa 8000 Kubikmeter pro Stunde.

Die Kühlleistung kann beispielsweise 10 kWatt pro Kühlmodul 2 betragen.

Die in Geräte des Trägerracks 4 eintretende Luft hat beispielsweise eine Umgebungstemperatur T1 von 21 Grad Celsius. Durch die Komponenten der Geräte des Trägerracks 4 wird die Temperatur der die Komponenten umströmenden Luft erhöht. Die Austrittstemperatur T2 der Luftströmung an der Abluftseite des Trägerracks 4 beträgt beispielsweise 35 Grad Celsius. Die erwärmte Luft an der Abluftseite des Trägerracks 4 strömt mit der erhöhten Temperatur T2 von beispielsweise 35 Grad Celsius durch ein Luftfilter des zugehörigen Rack-Kühlmoduls 2 hindurch in ein Kühlsegment 5 des Rack-Kühlmoduls 2 hinein und wird dort wieder auf die Umgebungstemperatut T1 abgekühlt. Mit dieser niedrigen Umgebungstemperatur T1 strömt die Luft in die Zuluft-Seite des nächsten Trägerracks 4 ein.

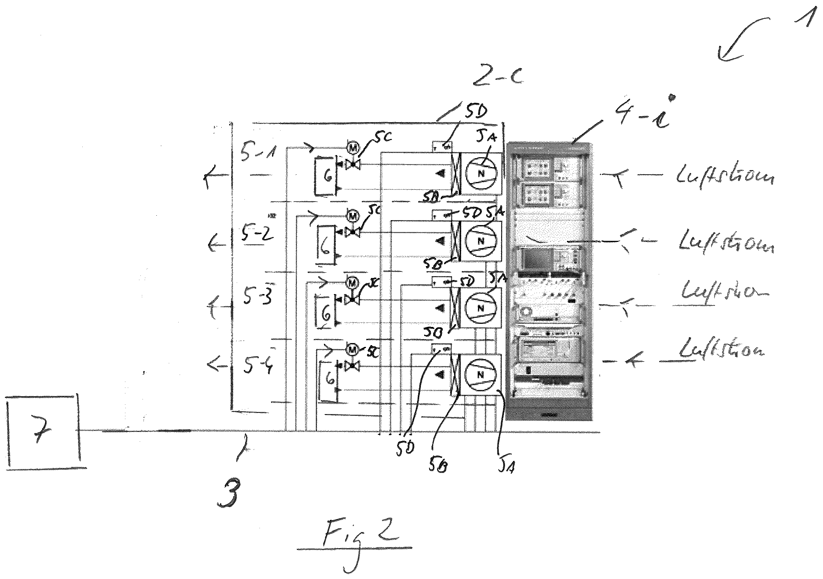

Bei einer möglichen Ausführungsform weist das Rack-Kühlmodul 2 mehrere übereinander angeordnete Kühlsegmente 5 auf, wie in Figur 2 dargestellt. Bei einer möglichen Implementierung weist das Rack-Kühlmodul 2 vier übereinander angeordnete Kühlsegmente 5-1,5-2,5-3,5-4 auf, wie in Figur 2 gezeigt. Jedes Kühlsegment 5-1 weist eine eigene Luftströmung auf, wie in Fig.2 dargestellt. Hierdurch kann eine individuelle Temperurregelung für verschiedene Geräte innerhalb des innerhalb des danebengelegenen Trägerracks 4 erreicht werden,

Bei einer möglichen Ausführungsform weist jedes Kühlsegment 5-i einen steuerbaren Luftventilator 5A auf, der zum Ansaugen der von Komponenten des Trägerracks 4 erwärmten Luftströmung durch den zugehörigen Luftfilter hindurch in das Kühlsegment 5 vorgesehen ist. Bei der in Figur 2 dargestellten Ausführungsform weist jedes Kühlsegment 5 ferner einen Wärmetauscher 5B auf, der über ein mit Hilfe eines Stellmotors M steuerbares Regelventil 5C mit einem Kaltwassernetz 6 verbunden ist.

Bei einer mögliche Ausführungsform erhält das steuerbare Regelventil 5C des Kühlsegments 5 Steuersignale über den Feld-Bus 3 von einer externen Steuerung 7 des Kühlsystems 1.

Bei einer möglichen Ausführungsform weist jedes Kühlsegment 5 zudem einen eigenen Wärmesensor bzw. Temperatursensor 5D zur Messung einer lokalen Temperatur T innerhalb des Kühlsegments 5 auf. Bei einer möglichen Ausführungsform ist der Wärmesensor 5D des Kühlsegments 5 ein Kanal-Mittelwertfühler ist. Der Wärmesensor 5D erzeugt Temperaturdaten, die über den Feld-Bus 3 an die externe Steuerung 7 des Kühlsystems 1 übertragen werden.

Bei einer möglichen Ausführungsform weist jedes Kühlsegment 5 des Rack-Kühlmoduls 2 eine Kondenswasser-Wanne zur Aufnahme von Kondenswasser auf, das sich innerhalb des Kühlsegments 5 bildet. Bei einer mögliche Ausführungsform läuft das in der Kondenswasser-Wanne des Kühlsegments 5 aufgenommene Kondenswasser über einen Ablauf in einen Sammelbehälter des Rack-Kühlmoduls 2 ab. Der Sammelbehälter des Rack-Kühlmoduls 2 weist vorzugsweise einen Leckage-Sensor zur Erfassung von in dem Sammelbehälter gesammelten Kondenswasser auf. Ferner ist an dem Sammelbehälter des Rack-Kühlmoduls 2 vorzugsweise eine Kondenswasser-Pumpe zum Abpumpen des in dem Sammelbehälter gesammelten Kondenswassers vorgesehen.

Bei einer möglichen Ausführungsform ist der Leckage-Sensor des Sammelbehälters über den Feld-Bus 3 mit einer externen Steuerung 7 des Kühlsystem 1 verbunden und meldet das Vorhandensein von Kondenswasser in dem Sammelbehälter an die externe Steuerung 7.

Bei einer möglichen Ausführungsform vergleicht die Steuerung 7 die von dem Wärmesensor 5D eines Kühlsegments 5 gemessene Ist-Temperatur (Tist) mit einer Soll-Temperatur (Tsoll) des betreffenden Kühlsegments 5 und steuert das Regelventil 5C des Kühlsegments 5 bis zum Erreichen der Soll-Temperatur individuell an.

Bei einer möglichen Ausführungsform ist das Rack-Kühlmodul 2 als Slave über den Feld-Bus 3 zur Datenübertragung an die externe Steuerung 7 als Master angeschlossen, wie in Figur 1 dargestellt.

Bei einer möglichen Ausführungsform weist der Feld-Bus 3 auch Stromversorgungsleitungen zur Stromversorgung von Einheiten der Kühlsegmente 5 des Rack-Kühlmoduls 2 auf.

Bei einer möglichen Ausführungsform ist das Rack-Kühlmodul 2 werkzeuglos an die Abluftseite des zugehörigen Trägerracks 4 (Plug and Play) anbringbar.

Das Kühlsystem 1 dient zum Kühlen von mehreren Trägerracks 4 innerhalb eines Integrationsraumes, wobei an der Abluftseite eines jeden Trägerracks 4 ein zugehöriges Rack-Kühlmodul 2 angebracht ist. Bei einer mögliche Ausführungsform des Kühlsystems 1 trägt jedes Trägerrack 4 mehrere Messgeräte deren Komponenten während des Betriebes Wärme Q erzeugen, die an der Abluftseite des Trägerracks 4 an das zugehörige Rack-Kühlmodul 2 abgeführt wird.

Das erfindungsgemäße Kühlsystem 1 erlaubt die Optimierung der Kühlung von Integrationsräumen und trägt somit der permanenten Erhöhung von eingebrachten Wärmelasten aufgrund immer höherer Leistungsanforderungen Rechnung. Ebenso wird mit Hilfe des erfindungsgemäßen Kühlsystem 1 eine akustische Belastung bei umliegenden Büro- bzw. Laborplätzen verringert.

Die Kühlracks bzw. Rack-Kühlmodule 2 werden an der Ausgangsseite bzw. Abluftseite der Trägerracks 4 angebracht (Luftrichtung rechts nach links in Fig.1) . Auf der Ausgangsseite des Rack-Kühlmoduls 2 wird dann ein weiteres Trägerrack 4 montiert. Den Abschluss bildet dann wieder ein Rack-Kühlmodul 2 um die Raumtemperatur nicht zu erhöhen (Raumtemperatur = Ansaugtemperatur). Auf der Übergabestation kann ein Schaltschrank mit einem ecos 504 montiert werden. Dieser Schaltschrank beherbergt mehrere Sicherungsabgänge, sowie zwei BUS-Linien.

Bei dem erfindungsgemäßen Kühlsystem 1 kann die Kühlung erweitert werden, ohne dass ein Umbau erfolgen muss oder ein weiterer Kabelzug vorgesehen werden muss. Es wird ein "Plug an Play"-Vorgehen erreicht. Eine erste Linie des Feld-Busses 3 hat beispielsweise eine Kapazität von bis zu drei Slaves, eine zweite Linie des Feldbusses 3 hat eine Kapazität von beispielsweise bis zu vier Slaves.

Jedes Kühlmodul 2 kann mehrere Kühlsegmente 5 aufweisen, welche durch die externe Steuerung 7 jeweils individuell angesteuert werden können. Hierdurch kann abhängig von der Auslastung der Rackeinbauten bzw. der Messgeräte des Trägerracks 4 die Kühlung gezielt und bedarfsgerecht angesteuert werden.

An dem Leckage-detektor kann eine Störmeldung potenzialfrei abgegriffen werden und der Steuerung 7 gemeldet werden.

Es wird vorzugsweise eine Zuluft-Temperaturregelung pro Kühlsegment 5 umgesetzt, d.h. bei dem in Figur 2 dargestellten Ausführungsbeispiel ergeben sich vier unabhängige Regelungen für vier Kühlsegment 5-1 bis 5-4 pro Kühlmodul 2.

Die Regelungen können durch die Steuerung 7 unabhängig in Echtzeit durchgeführt werden. Die Soll-Temperaturen (Tsoll) für die verschiedenen Kühlsegmente 5 sind dabei unabhängig voneinander einstellbar.

Die Einstellung der verschiedenen Soll-Temperaturen Tsoll kann in Abhängigkeit der Konfiguration der in dem zugehörigen Trägerrack 4 verbauten Geräte erfolgen.

Das erfindungsgemäße Kühlsystem 1 bietet eine präzise und stabile Temperatur-Regelung, die eine Genauigkeit von 1 bis 3 Kelvin (1-3 K) aufweist. Das erfindungsgemäße Kühlsystem 1 bietet zudem mehr Flexibilität in der erreichten Kühlleistung d.h. höhere Wärmelasten sind möglich.

Ein weiterer Vorteil des erfindungsgemäße Kühlsystems 1 ist seine geringere Geräuschentwicklung. Ferner bewirkt der stark verringerte Luftstrom im Aufstellungsraum der Trägerracks 4 weniger Lärm.

Das erfindungsgemäße Kühlsystem 1 hat eine höhere Energieeffizienz als herkömmliche Rack-Kühlsysteme aufgrund der direkten Kühlung am Ort der Entstehung der Wärme Q.

Das erfindungsgemäße Kühlmodul 2 dient zur direkten Kühlung der Komponenten innerhalb eines Trägerracks 4. Das Kühlmodul 2 wird an der Abluftseite des Trägerracks 4 aufgestellt bzw. an der Abluftseite montiert. Das Kühlmodul 2 verfügt über regulierbare Ventilatoren und Ventile. Hierdurch kann mehr Wärmelast direkt abgeführt bzw. mehr Kälteleistung direkt an der Lastquelle zur Verfügung gestellt werden.

## Patentansprüche

1. Rack-Kühlmodul (2) für ein Trägerrack (4), wobei das Rack-Kühlmodul (2) an einer Abluftseite des Trägerracks (4) zum Kühlen einer von Komponenten des Trägerracks (4) erwärmten Luftströmung, die quer zu einem Bedienfeld des Trägerracks (4) horizontal verläuft, anbringbar ist.

2. Rack-Kühlmodul nach Anspruch 1, wobei die von Komponenten des Trägerracks (4) erwärmte Luftströmung durch ein Luftfilter in mindestens ein zugehöriges Kühlsegment (5) des Rack-Kühlmoduls (2) gesaugt wird.

3. Rack-Kühlmodul nach Anspruch 2, wobei das Rack-Kühlmodul (2) mehrere übereinander angeordnete Kühlsegmente (5,1,5-2,5-3,5-5-4) aufweist.

4. Rack-Kühlmodul nach Anspruch 2 oder 3, wobei das Kühlsegment (5) einen steuerbaren Luftventilator (5A) zum Ansaugen der von Komponenten des Trägerracks (4) erwärmten Luftströmung durch den zugehörigen Luftfilter hindurch in das Kühlsegment (5) hinein aufweist.

5. Rack-Kühlmodul nach Anspruch 4, wobei das Kühlsegment (5) einen Wärmetauscher (5B) aufweist, der über ein steuerbares Regelventil (5C) mit einem Kaltwassernetz (6) verbunden ist.

6. Rack-Kühlmodul nach Anspruch 5 wobei das steuerbare Regelventil (5C) des Kühlsegments (5) Steuersignale über einen Feld-Bus (3) von einer externen Steuerung (7) erhält.

7. Rack-Kühlmodul nach einem der vorangehenden Ansprüche 2 bis 6, wobei das Kühlsegment (5) einen Temperatursensor (5D) zur Messung einer lokalen Temperatur innerhalb des Kühlsegments (5) aufweist.

8. Rack-Kühlmodul nach Anspruch 7, wobei der Temperatursensor (5D) des Kühlsegments (5) ein Kanal-Mittelwertfühler ist.

9. Rack-Kühlmodul nach Anspruch 7 oder 8, wobei der Temperatursensor (5D) Temperaturdaten erzeugt, die über einen Feld-Bus (3) an eine externe Steuerung (7) übertragen werden.

10. Rack-Kühlmodul nach einem der Ansprüche 2 bis 6, wobei das Kühlsegment (5) eine Kondenswasser-Wanne zur Aufnahme von Kondenswasser, das sich innerhalb des Kühlsegments (5) bildet, aufweist.

11. Rack-Kühlmodul nach Anspruch 10, wobei das in der Kondenswasser-Wanne des Kühlsegments (5) aufgenommene Kondenswasser über einen Ablauf in einen Sammelbehälter des Rack-Kühlmoduls (2) abläuft, der einen Leckage-Sensor zur Erfassung von in dem Sammelbehälter gesammelten Kondenswasser und eine Kondenswasser-Pumpe zum Abpumpen des in dem Sammelbehälter gesammelten Kondenswassers aufweist.

12. Rack-Kühlmodul nach Anspruch 11 wobei der Leckage-Sensor des Sammelbehälters über einen Feld-Bus (3) mit einer externen Steuerung (7) verbunden ist und das Vorhandensein von Kondenswasser in dem Sammelbehälter des Rack-Kühlmoduls (2) an die externe Steuerung (7) meldet.

13. Rack-Kühlmodul nach einem der vorangehenden Ansprüche 9-12, wobei die Steuerung (7) die von dem Temperatursensor (5D) eines Kühlsegments (5) gemessene Ist-Temperatur mit einer Soll-Temperatur des betreffenden Kühlsegments (5) vergleicht und das Regelventil (5C) des Kühlsegments (5) zum Erreichen der Soll-Temperatur individuell ansteuert.

14. Rack-Kühlmodul nach einem der vorangehenden Ansprüche 1-13, wobei das Rack-Kühlungsmodul (2) als Slave über einen Feld-Bus (3) zur Datenübertragung an eine externe Steuerung (7) als Master angeschlossen ist.

15. Rack-Kühlmodul nach Anspruch 14, wobei der Feld-Bus (3) Stromversorgungsleitungen zur Stromversorgung der Kühlsegmente (5) des Rack-Kühlmoduls (2) aufweist.

16. Rack-Kühlmodul nach einem der vorangehenden Ansprüche 1 - 15, wobei das Rack-Kühlmodul (2) werkzeuglos an die Abluftseite des Trägerracks (4) anbringbar ist.

17. Kühlsystem (1) zum Kühlen von mehreren Trägerracks (4) innerhalb eines Integrationsraumes, wobei an einer Abluftseite eines jeden Trägerracks (4) ein zugehöriges Rack-Kühlmodul (2) nach einem der vorangehenden Ansprüche 1-16 angebracht ist.

18. Kühlsystem nach Anspruch 17, wobei das Trägerrack (4) Messgeräte trägt deren Komponenten während des Betriebes Wärme erzeugen, die an der Abluftseite des Trägerracks (4) an das zugehörige Rack-Kühlmodul (2) abgeführt wird.
